# EUROPEAN PATENT APPLICATION

(11) **EP 1 202 019 A1**
(43) Date of publication of application: **02.05.2002**
(21) Application number: 00309329.1
(22) Date of filing: 23.10.2000
(51) Int. Cl.: F28F 13/12, F04D 29/58, H05K 7/20

(54) **Heat exchanger**

(71) Applicant: LUCENT TECHNOLOGIES INC., Murray Hill, New Jersey 07974-0636 (US)
(72) Inventor: Ewes, Ingo, Nuernberg 90409 (DE)
(74) Representative: Buckley, Christopher Simon Thirsk

(57) **Abstract**

The invention relates to a recuperator (1) for fluid media (11, 12). A rotor (4) consisting of two portions (8a, 8b) comprises a multiplicity of thermally conductive bars (8) which run parallel to the axis of rotation (5) and pass through a middle wall (7). At the same time, one of the portions (8b) rotates in a first fluid (12) and from this absorbs heat which is conducted via the bars (8) into the other portion (8a) and is discharged there to a second fluid (11). The rotor (4), in this case, performs the double function of generating the fluid flows (11, 12) and of heat conduction, the formation of turbulence having proved to be conducive to the transmission of heat.

## Description

### Field of the invention

The invention relates to a heat exchanger, to a device with a heat exchanger and also to a method for the transmission of heat in general and to a recuperator for fluid media in particular.

### Background of the invention

The object of transmitting heat from a hot medium to a cold medium is of growing importance, particularly for the recovery of heat and the operation of electrical and electronic appliances. These appliances generate, sometimes to a considerable extent, waste heat which is a result of power loss. In order, for example, to avoid exceeding a component-specific maximum temperature, it is therefore often necessary to discharge this waste heat in a controlled manner.

A particularly simple solution, such as is employed, for example, for computers, is to use a fan, either within a housing for reinforcing the internal air circulation or in an orifice in the appliance housing for the discharge of heated air from the inside outwards. The air exchange, as a consequence of the principle adopted in the latter case, between the hot air inside the housing and the cold air outside the housing is a disadvantage, since it causes increased dirt and moisture pollution. Such a cooling method, which is based on the exchange of the heat-carrying medium, is unsuitable, furthermore, when mass transfer between the cold and hot medium is expedient or necessary. Examples of this are the contamination of one of the two media with pollutants or the difference between the two media.

There is therefore a great need for heat exchangers which manage without appreciable mass transfer between the hot and cold fluid medium or, in brief, the fluid. Such an exchanger, in which a separation of the heat transfer media is ensured, is designated as a recuperator.

Known recuperators consist essentially of an arrangement of plates or cartridges, through which the two air streams are led past one another in such a way that a heat flow goes from the hotter air stream to the colder air stream. In order to drive the air streams through this arrangement, the recuperator typically possesses, in the two air circuits, fans which build up the necessary pressure difference. It is a disadvantage that, in a recuperator assembled as a compact unit, these fans take up a considerable part of the volume which is therefore no longer available for actual heat transmission. Moreover, the ratio of the electrical power used to the cooling capacity is relatively poor.

One object of the invention is, therefore, to make available a compact and cost-effective heat exchanger with high cooling capacity, which achieves good separation between the hot and the cold fluid.

Another object of the invention is to make available a heat exchanger which reduces or avoids the disadvantages of the prior art.

These objects are achieved by means of the heat exchanger according to Claim 1 and the method according to Claim 12.

The heat exchanger according to the invention comprises a rotor, a separation between a first and a second fluid and an arrangement rotatable about an axis of the rotor and composed of thermally conductive elements. Furthermore, in the heat exchanger according to the invention, a first and a second portion of the arrangement are arranged respectively on a first and a second side of the separation, and the first and the second portion of the arrangement are located, preferably permanently, respectively in the first and the second fluid during the rotation of the rotor, thus ensuring that the two fluids are separated. The heat is consequently first transmitted from the first fluid to the first portion of the arrangement composed of thermally conductive elements and conducted via the latter from the first portion into the second portion. Heat transmission subsequently takes place from the second portion of the arrangement to the second fluid. The rotation of the thermally conductive elements through the respective fluids gives rise to a good intermixing of the fluids and their flow through the arrangement. An effective incoming and outgoing transport of the heat within the fluids is thus ensured. Consequently, the heat exchanger according to the invention can advantageously be used in any installation position. The thermally conductive elements therefore assume the double function of heat conduction and driving the fluid stream.

Advantageously, in the invention, the volume of the heat exchanger is used essentially for the arrangement composed of thermally conductive elements, so that a large overall cross section of thermally conductive elements is achieved. Furthermore, the heat exchanger can be produced cost-effectively in a compact design and requires only one drive for the rotor, with the result that the drive power used is effectively utilized.

Advantageously, the heat exchanger according to the invention, simply by the gap being minimized between the separation and an orifice located in an external wall, makes it possible to have a good mass transfer between the first and the second fluid. The mass transfer is further improved preferably by means of an annular and cross-sectionally U-shaped seal in which the outer border of the separation runs.

The thermally conductive elements are produced preferably as bars which, for example, have a round, annular or blade-like cross section. This is conducive to the formation of strong turbulence in the fluids within the arrangement of thermally conductive elements, that is to say a high degree of turbulence is generated during rotation. The intended generation of turbulence is based on the surprising finding that heat transmission between the thermally conductive elements and the respective air streams is reinforced as a result.

On account of the simplicity, compactness and effectiveness of the heat exchanger according to the invention, the latter is suitable for a multiplicity of uses. These are, inter alia, the cooling of electrical appliances, for example in a closed cabinet, heat transmission in power stations, for example in the region of power/heat coupling or heat pumps, that is to say for controlled cooling or heating. Moreover, the heat exchanger according to the invention can be used for virtually all fluid media, that is to say liquids and gases. If the first and the second portion of the arrangement are designed suitably and, if appropriate, differently, the heat exchanger is suitable even for two media with greatly differing viscosity, for example a gas and a liquid.

Preferably, the thermally conductive elements are manufactured from a light material with a high conductivity constant, for example from aluminium.

In an advantageous development of the invention, the thermally conductive elements pass through the separation or are formed in one piece with this. The advantage of the latter variant is that the rotor can be produced in a simple way and additional heat conduction, even in the interspace between the thermally conductive elements, takes place via the separation, for example in the form of a round disc centred about the axis.

Preferably, the separation extends in one plane perpendicularly to the axis and the thermally conductive elements extend parallel to the axis.

A development of the invention comprises an annular cover which is secured to the arrangement of thermally conductive elements in their end region, that is to say rotates together with the rotor. During rotation, the respective fluid is thereby sucked in axially through the central orifice in the cover and, driven by inertia forces, flows radially out of the arrangement, with the result that the transport of heat is improved even further.

Preferably, a non-rotating housing is located with one or more orifices above one side or above both sides of the exchanger, so that the fluid flows out through the fixed orifices directionally on at least one side of the separation.

A further aspect of the invention is implemented by a device which comprises the heat exchanger according to the invention and a cabinet, for example an electronic cabinet. The heat exchanger is secured in an orifice of a wall of the cabinet. If a housing is used, this may be fastened to the wall.

The invention is explained in more detail below by means of exemplary embodiments and with reference to the drawings.

### Brief description of the drawings

In the drawings:
- Figure 1: shows a section through the heat exchanger along the axis,
- Figure 2: shows a perspective view of a detail from an arrangement of thermally conductive elements, and
- Figure 3: shows a section through an electronic cabinet with a built-in heat exchanger according to the invention.

### Detailed description of the invention

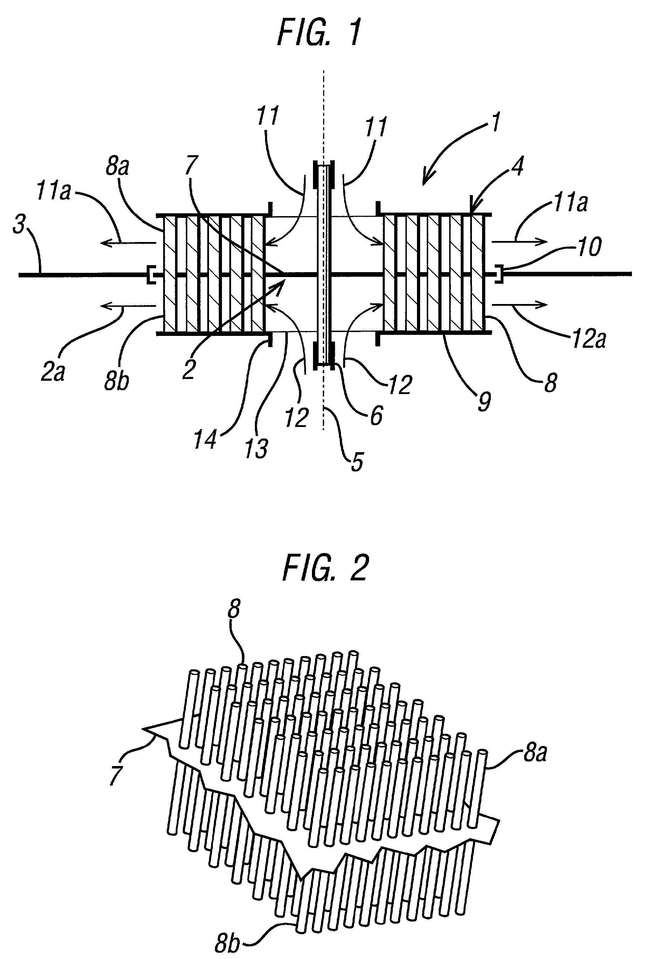

Figure 1 shows the heat exchanger 1 according to the invention, which is fastened fixedly in an orifice 2 of a stationary wall 3. A rotor 4 in the form of a running wheel rotates about an axis 5 which is mounted in bearings 6. The rotor 4 comprises a separation in the form of a middle wall 7, an arrangement or multiplicity of thermally conductive elements in the form of solid round bars 8 and a cover disc 9. The rotor 4 is designed to be rotationally symmetrical about the axis 5 and mirror-symmetrical with respect to the middle wall 7 and is therefore subdivided by the middle wall 7 into an upper and a lower portion. The bars 8 pass through the middle wall 7, so that the upper and the lower portion 8a, 8b of the bars 8 are located respectively on the upper and the lower side of the middle wall. When the rotor rotates, the middle wall 7 and also the cover disc 9 rotate and the thermally conductive round bars 8 run about the axis 5, so that the upper and the lower portion 8a, 8b are permanently located respectively in cold and hot air 11, 12 separated from one another. The middle wall 7 is only minimally smaller than the orifice 2 and is additionally sealed off with respect to the stationary wall 3 by means of a seal 10. Mass transfer between the cold air 11 and the hot air 12 is thereby effectively suppressed. Furthermore, the cover disc 9 possesses, centred about the axis 5, a circular hole 13 which is led further outwards through a circular ring 14 on both sides. During the rotation of the rotor, the air located in the rotor is thrown out radially due to the centrifugal forces, so that, in counteraction, new air is sucked in through the hole 13 as a result of the vacuum which is generated. A good flow through the arrangement composed of thermally conductive bars 8 is thus achieved. When the air 11, 12 flows past the thermally conductive bars 8, convective heat transfer takes place according to the local temperature difference between the air and the bar surface. The heat transmitted from the hot air 12 to the bars 8 is transmitted by heat conduction from the lower portion 8b of the bars 8 to the upper portion 8a of the cold-air side. There, by convective heat transfer, the heat is transmitted from the bar surface to the cold air 11.

In a particularly effective and at the same time simple configuration of the thermally conductive elements 8, these are designed as a regular grid of closely arranged bars. Figure 2 shows a detail of such a bar grid. In the simplest instance, the cross-sectional shape of the bars 8 is circular or annular, but other shapes, such as, for example, that of a short curved blade, have also proved advantageous. By virtue of the high tangential velocity of the bars 8, the air is entrained and is accelerated radially due to the centrifugal forces. The rotational speed of the rotor 4, the arrangement density of the bars 8 and the bar shape determine the mass airflow throughput. This is of such a magnitude that a sufficient driving temperature difference is maintained between the hot and the cold air flow 12, 11. The turbulent flow around the bars 8 results in a high degree of heat transfer between the air 11, 12 and the bar surface. Consequently, with the bars being suitably dimensioned and arranged, a high transmitted heat flow from the hot side to the cold side can be achieved.

Heat conduction via the blade leaves or bars assumes an important proportion of the transport of heat, and therefore these are produced from a material with a high thermal conductivity constant, from aluminium in this embodiment.

In an important aspect of the invention, the arrangement is optimized not solely with regard to the conveyance of air, but additionally with regard to the transmission of heat from the cold and the hot fluid 11, 12, here air in each case, respectively to the upper and the lower portion 8a, 8b of the bars 8. The turbulence, which gives rise to flow losses, at the same time increases the transmission of heat. This is an appreciable advantage, as compared with known heat exchangers, in which the flow losses occurring in the fans constitute a disadvantageous parasitic effect.

Advantageously, as can be seen in Figure 1, a large part of the rotor is filled with the arrangement of bars 8. Only a small fraction of the volume is required for the inflow orifice 13. The heat exchanger according to the invention therefore acquires an extremely compact form of construction.

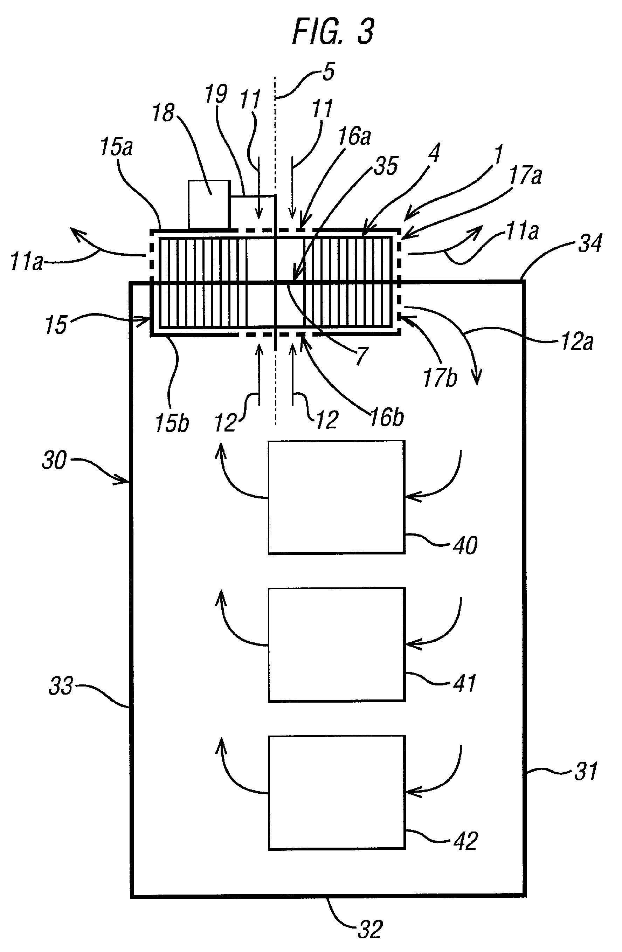

Figure 3 shows an electronic cabinet 30 which is closed on all sides, so as to be essentially fluid-tight, by means of outer walls 31, 32, 33, 34. The upper outer wall or top 34 of the electronic cabinet 30 possesses an orifice 35, in which the rotor 4 of the heat exchanger 1 is arranged and rotates. The middle wall 7 of the rotor 4 is sealed relative to the top 34 essentially by the gap being minimized. The axis 5 of the rotor 4 runs perpendicularly to the horizontal top 34, with the result that the plane of rotation lies parallel to the top 34. A housing 15, consisting of a portion 15a outside the cabinet and of a portion 15b inside the cabinet, surrounds the rotor 4. The housing 15 is secured fixedly relative to the top 34 and protects the rotor 4 against contact. Various air ductings of the inner and the outer air stream 12, 11 can be implemented by means of different configurations of orifices in the housing 15. A particularly advantageous air ducting is described below.

The outer portion 15a of the housing 15 has a central inflow orifice 16a for the outer air 11. The edge region of the outer housing portion 15a has an orifice 17a which is annular about the axis 5, so that the outflowing outer air 11a can escape from the heat exchanger horizontally in all directions. This ensures a maximum air throughput. The inner portion 15b of the housing 15 likewise has an inflow orifice 16b, centred about the axis 5, for the inner air 12. In contrast to the outer portion 15a, the inner portion 15b of the housing 15 has only one outflow orifice 17b for the escaping inner air 12a, said outflow orifice being made on the right-hand side. A directed air circulation is thereby brought about within the electronic cabinet 30. The hot air rises on the left-hand side of the cabinet from the electronic appliances 40, 41, 42 to be cooled, passes into the heat exchanger through the inflow orifice 16b, is blown out of the outflow orifice 17b by said heat exchanger and falls again on the right-hand side of the electronic cabinet 30, in order once again to reach the electronic appliances 40, 41, 42. At the same time, the heat loss from the inner air 12 in the electronic cabinet 30 is transmitted to the surrounding outer air 11. However, the running wheel or turbine wheel 4, because it functions independently of its position, may also be inserted in another, for example vertical, outer wall.

It is particularly advantageous for the motor 18, together with a rotor drive 19, to be arranged in such a way that their heat loss is absorbed by the outer air stream 11. In particular, the heat exchanger 1 according to the invention requires only one drive motor 18, so that, since the latter is mounted in the outer region of the electronic cabinet 30, there is no additional heat loss generated within the electronic cabinet 30.

It is obvious to a person skilled in the art that the embodiments shown by way of example in Figures 1 to 3 are to be understood as being illustrative and that the heat exchanger according to the invention may be varied in many ways, particularly by virtue of different designs of the arrangements of thermally conductive elements, without departing from the spirit of the invention.

## Claims

1. Heat exchanger (1) with a rotor (4), with a separation (7) between a first and a second fluid (12, 11) and with an arrangement rotatable about an axis (5) of the rotor (4) and composed of thermally conductive elements (8), a first and a second portion (8b, 8a) of the arrangement being arranged respectively on a first and a second side of the separation (7), the first and the second portion (8b, 8a) of the arrangement being located respectively in the first and the second fluid (12, 11) during the rotation of the rotor (4), and heat being capable of being conducted from the first portion (8b) into the second portion (8a) of the arrangement via the thermally conductive elements (8).

2. Heat exchanger (1) according to Claim 1, in which the thermally conductive elements (8) pass through the separation (7) or are formed in one piece with the latter.

3. Heat exchanger (1) according to Claim 1 or 2, in which the separation comprises a disc (7) essentially perpendicular to the axis (5) and centred and rotatable about the axis (5), and the thermally conductive elements (8) are designed to be bar-shaped, in the form of a round bar and/or blade-like.

4. Heat exchanger (1) according to one of the preceding claims, in which the thermally conductive elements (8) extend essentially parallel to the axis (5).

5. Heat exchanger (1) according to one of the preceding claims, in which the thermally conductive elements (8) consist essentially of a metal with a high conductivity constant, in particular of aluminium or of an aluminium-containing alloy.

6. Heat exchanger (1) according to one of the preceding claims, in which a fluid stream (12, 11) is capable of being sucked in axially and of flowing out radially in each case in the first and/or the second portion (8b, 8a) of the arrangement as a result of the rotation of the rotor.

7. Heat exchanger (1) according to one of the preceding claims, in which, due to rotation, turbulent flows in the first and/or the second fluid (12, 11) are capable of being formed in the region of the thermally conductive elements (8).

8. Heat exchanger (1) according to one of the preceding claims, in which a cover (9) rotatable together with the arrangement is mounted on at least one side of the separation (7) in the region of the ends of the thermally conductive elements (8) and comprises a round disc (9) centred about the axis (5) and having a central orifice (13).

9. Heat exchanger (1) according to one of the preceding claims, comprising a housing (15) which surrounds the first and/or the second portion (8b, 8a) of the arrangement and in the radial direction defines a fixed air outlet orifice (17b).

10. Device, comprising a heat exchanger (1) according to one of the preceding claims and a cabinet (30) with an outer wall (34), the heat exchanger (1) being arranged in an orifice (35) or recess of the outer wall (34), one (12) of the two first and second fluids (12, 11) being located inside the cabinet (30) and the other (11) of the two first and second fluids (12, 11) being located outside the cabinet (30).

11. Device according to Claim 10, in which the axis (5) of the rotor (4) runs essentially perpendicularly to the outer wall (34), and the separation (7) is arranged, essentially parallel to the outer wall (34), in the orifice or recess (35), so as to close off in an essentially fluid-tight manner.

12. Method for the transmission of heat, in which a rotor (4) together with an arrangement composed of thermally conductive elements (8) rotates about an axis (5), during rotation a first and a second portion (8b, 8a) of the arrangement being permanently located respectively in a first and a second fluid (12, 11) and the fluids (12, 11) being essentially separated from one another by means of a separation (7), a fluid stream (12, 11) being sucked in axially, in each case in a region near the axis (5), on both sides of the separation (7) in each case, and the two fluid streams (12, 11) flowing out of the device radially through the corresponding portion (8b, 8a) of the arrangement composed of thermally conductive elements (8), and heat being transmitted from the first fluid (12) to the first portion (8b) of the arrangement, heat being conducted via the arrangement from the first portion (8b) on one side of the separation (7) to the second portion (8a) on another side of the separation (7), and heat being transmitted from the second portion (8a) of the arrangement to the second fluid (11).

13. Method according to Claim 12, in which the first and/or the second fluid (12, 11) flow turbulently in the region of the thermally conductive elements (8).
